# EUROPEAN PATENT APPLICATION

(11) **EP 2 416 328 A2**
(43) Date of publication of application: **08.02.2012**
(21) Application number: 10758997.0
(22) Date of filing: 30.03.2010
(51) Int. Cl.: H01B 1/22, H01L 31/042, H05K 3/40

(54) **LOW TEMPERATURE FIREABLE PASTE COMPOSITION FOR FORMING AN ELECTRODE OR WIRING**

(30) Priority: 01.04.2009 KR 20090028239
(71) Applicant: Dongjin Semichem Co., Ltd., Seo-gu Incheon 404-205 (KR)
(72) Inventor: HWANG, Kun-Ho, Gyeonggi-Do 445-931 (KR); JUNG, Yong-Jun, Gyeonggi-Do 445-931 (KR); KO, Min-Soo, Gyeonggi-Do 445-931 (KR); JEONG, Mee-Hye, Gyeonggi-Do 445-931 (KR)
(74) Representative: Bockhorni & Kollegen
(86) International application number: PCT/KR2010/001917
(87) International publication number: WO 2010/114272

(57) **Abstract**

The invention is directed to a paste composition used for forming an electrode or wiring, wherein it comprises a) a conductive powder; b) a cellulose binder; c) an acrylate monomer; d) a radical polymerization initiator; and e) a solvent, and it is curable at a low temperature when compared to the prior paste compositions and it has excellent hardness, electrical resistivity and stability so that it can be usefully used for forming an electrode or wiring for a solar cell, RFID (Radio Frequency Identification) or PCB (Printed Circuit Board).

## Description

### FIELD OF THE INVENTION

The invention relates to a low-temperature curable paste composition used for forming an electrode or wiring, and more particularly, to a thermosetting paste composition that is curable at a low temperature and has such an excellent electrical resistivity and stability that it can be usefully used for forming an electrode or wiring for a solar cell, RFID (Radio Frequency Identification) or PCB (Printed Circuit Board).

### BACKGROUND OF THE INVENTION

Prior paste compositions used for forming electrodes or wirings have been prepared by blending conductive powders, epoxy binders, hardening agents, solvents, and so on.

When the prior paste compositions were hardened by heat, urethane compounds were generated. The thus generated urethane compounds have drawbacks in that they severely deteriorate the adhesion and weldability of Ag particles that have been mostly used as conductive powders. Furthermore, the prior paste compositions have caused diffusion of line width, thereby making it difficult to achieve electrode pattern with high resolution. See Korean Laid-Open Patent Nos. 10-2006-0049996 and 10-2008-0024444, and Japanese Laid-Open Patent Nos. 2005-268239, 2006-48149 and 2007-224191.

Therefore, there have been efforts of developing paste compositions used for forming electrodes or wirings, having high hardness and excellent stability without deteriorating adhesiveness of conductive powders, by selecting organic materials such as binders and polymerization initiators used along with the conductive powders.

### SUMMARY OF THE INVENTION

Therefore, it is an object of the invention to provide a thermosetting paste composition that is useful for forming an electrode or wiring, being curable at a low temperature and having excellent hardness, electrical resistivity and stability, when compared to the prior paste compositions used for forming electrodes or wirings, and a method of forming an electrode or wiring using it.

To achieve the object of the invention, the present invention provides a paste composition used for forming an electrode or wiring, comprising
a) a conductive powder;
b) a cellulose binder;
c) an acrylate monomer;
d) a radical polymerization initiator; and
e) a solvent.

Further, the invention provides a method of forming an electrode or wiring, comprising coating the above paste composition onto a substrate, drying and curing it.

Further, the invention provides an electrical or optical element characterized by comprising the electrode or wiring formed by the method of forming the electrode or wiring.

The paste composition used for forming an electrode or wiring of the present invention,
1) has excellent printing performance, thereby achieving electrode pattern with high resolution;
2) has superior rheology, thereby achieving a high aspect ratio;
3) has excellent hardness, thereby obtaining excellent electrical resistivity even at low temperatures (400°C or under);
4) has slight viscosity change, thereby being stably stored; and
5) exhibits a high adhesiveness regardless of the texture of substrates (polymers, glass, metals, ceramic and so on), thereby being applicable to a wide variety of fields such as solar cells, RFID and PCB.

### DETAILED DESCRIPTION OF THE INVENTION

The paste composition used for forming an electrode or wiring according to the present invention is characterized by comprising a) a conductive powder; b) a cellulose binder; c) an acrylate monomer; d) a radical polymerization initiator; and e) a solvent, wherein its reaction temperature is between 80 and 150°C so that it is not spontaneously hardened at a room temperature and thus can be stored at 80°C or lower temperatures without any risk of being degraded, and it is curable at as low temperatures as 150-400°C.

Preferably, the paste composition of the present invention may comprise a) 30 to 90 % by weight of a conductive powder; b) 1 to 30 % by weight of a cellulose binder; c) 1 to 30 % by weight of an acrylate monomer; d) 0.01% to 10 % by weight of a radical polymerization initiator; and e) a residual amount of a solvent.

In accordance with the invention, a) the conductive powder can be any metal powders which have been conventionally used for forming electrodes or wirings and silver (Ag) may be used as the most typical conductive powder. The conductive powder used in accordance with the invention may have an average particle size of 0.05 to 10 µm and preferably, 0.1 to 5 µm.

Further, the conductive powders can be used in a mixture of two or more kinds, wherein powders having a nano particle size of 0.05 to 1 µm and powders having a micro particle size of 1 to 10 µm may be used in a mixture of two or more kinds.

The conductive powders may have shape of sphere, non-sphere or plate-shape (flake shape), and they may be used in a mixture of two or more kinds.

In accordance with the present invention, b) the cellulose binder may be chosen from the group consisting of methylcellulose, ethylcellulose, propylcellulose, nitrocellulose, acetic acid cellulose, propionic acid cellulose, hydroxyethyl cellulose, hydroxyl propyl cellulose, hydroxyethylhydroxypropyl cellulose and a mixture thereof and preferably, ethylcellulose may be used.

In accordance with the present invention, c) the acrylate monomer may be, for instance, methacrylic acid, methacrylate, ethylglycidylether methacrylate, propylglycidylether methacrylate, 2 or 4-bromobenzyl methacrylate, hexylmethacrylate, n-octyl methacrylate, isooctyl methacrylate, 2-ethylhexyl methacrylate, isononyl methacrylate, ethylisoamylacrylate, butylglycidylether methacrylate, phenylglycidylether acrylate, tricyclodecyl methacrylate, phenyl methacrylate, benzyl methacrylate, 2 or 4-methoxyphenyl methacrylate, 2 or 4-methoxy benzyl methacrylate, 2 or 4-ethoxyphenyl methacrylate, 2 or 4-ethoxybenzyl methacrylate, 2 or 4-chlorophenyl methacrylate, 2 or 4-chloro benzyl methacrylate, 2 or 4-bromophenyl methacrylate, multi functional monomers such as trimethylolpropane triacrylate, ethyleneglycol dimethacrylate, triethyleneglycol dimethacrylate, 1,3-butanediol dimethacrylate, neopentylglycol dimethacrylate, 1,6-hexanediol dimethacrylate, trimethylol trimethacrylate, trimethylolpropane trimethacrylate, pentaerytritol trimethacrylate, ditrimethylolpropane tetramethacrylate, dipentaerythritol hexylmethacrylate or a mixture thereof and preferably, there may be used trimethylolpropane triacrylate, trimethylolpropane trimethacrylate or ethyleneglycoldimethacrylate.

In accordance with the present invention, d) the radical polymerization initiator may be any peroxide compounds that have been used for radical polymerization reaction. For example, there can be used as the peroxide initiator dilauroyl peroxide, dibenzoyl peroxide, tert-butyl peroxyneodecanoate, tert-amyl peroxypivalate, di(2-ethylhexyl)peroxydicarbonate, di(3-methoxy butyl peroxydicarbonate), 3-hydorxy-1,1-dimethylbutylperoxyneodecanoate, di(3,5,5-trimethylhexanoyl)peroxide, tert-amyl peroxy-2-ethylhexanoate, tert-butyl peroxy-2-ethylhexanoate, tert-butyl-isopropyl monoperoxycarbonate, tert-butylperoxy-2-ethylhexylcarbonate, dibenzoylperoxide, tert-amyl(2-ethylhexyl)monoperoxy carbonate, tert-buylperoxide, tetrabutylperoxide, tert-butylperoxy isopropyl carbonate, tert-butyl peroxy benzoate, 1,1,3,3-tetrametylbutyl peroxyneodecanoate, dicumylperoxide, didecanoyl peroxide or a mixture thereof and preferably, there can be used tert-butyl peroxide, tetrabutyl peroxide, dibenzoylperoxide, tert-butylperoxybenzoate, or tert-butylperoxyneodecanoate.

Furthermore, the paste composition used for forming an electrode or wiring in accordance with the invention may further comprise an additive that can be conventionally included in the pastes used for forming electrodes or wirings, if needed, in addition to the above-described ingredients. For example, the additives may include a plasticizer, thickening agent, stabilizer, dispersing agent, foaming agent and surfactant. Each additive can be included in an amount of 0.01 to 10 % by weight in the paste of the invention.

The paste composition can be prepared by evenly blending the conductive powder, cellulose binder, acrylate monomer, radical polymerization initiator and optional additives within a prescribed amount with the solvent using a blender or 3-roll mill.

The paste composition in accordance with the present invention may comprise the solvent in such an amount that a certain viscosity can be attained and preferably, it may have viscosity of 1 to 300 Pa.S when measured using Brookfield HBT Viscometer at #51 spindle with the condition of shear rate of 3.84 sec-1 under room temperature (25°C).

For the solvent, there can be used terpineol, butylcarbitolacetate, butylcarbitol, ethylene glycol, ethylene glycol monobutyl ether, ethylene glycol monobutyl ether acetate, butyleneglycol monomethylether, propylene glycol methyl ether acetate, dipropyleneglycol methyl ether acetate, propyleneglycol monomethylether propionate, ethylether propionate, propyleneglycol monomethylether acetate, dimethylamino formaldehyde, methylethylketone, gammabutyrolactone, ethyllactate, 2,2,4-trimethyl-1,3-pentanediol monoisobutylate(texanol), toluene, 1-methoxy-2-propanol or a mixture thereof

Further, the present invention provides a method of forming an electrode or wiring by coating the paste composition onto a substrate, drying and curing it. The electrode and wiring may be an electrode or wiring for solar cells, REID or PCB, and the solar cell, RFID or PCB in accordance with the present invention can be manufactured by conventional materials and methods with the exception of the formation of the electrode or wiring using the paste composition of the invention.

The electrode or wiring formed from the paste composition of the invention may have a thickness of 3 to 50 µm. In case of the solar cells, for instance, the substrate may be Si substrate onto which front electrode (ex: Ag electrode) has been coated and dried. The coating process can be carried out by screen printing, the drying can be carried out at 60 - 150 °C for 3 to 30 min, and the curing process can be carried out at 150 -400 °C for 5 to 60 min. Furthermore, the drying and curing process can be carried out at the same time, for instance, at low temperatures of 100-400 °C for 5 to 60 min.

As described in the above, the paste composition used for forming electrode or wiring in accordance with the invention has the following advantages:
1) High resolution: its superior rheology makes it easy to achieve high resolution pattern of 80 µm or lower.
2) High aspect ratio: its excellent screen mesh coming-out characteristics during printing make it possible to get high aspect ratio so that it is possible to obtain excellent wire resistance even at high resolution.
3) Superior electrical resistance at low temperature hardening of 400 °C or lower: excellent hardness is obtained by use of only small amounts of binders, monomers and polymerization initiators, and its electrical resistivity is excellent.
4) Excellent storage stability: hardening reaction is suppressed at a room temperature so that it has slight viscosity change in the condition of 25 to 40°C.
5) High hardness: it has excellent adhesiveness to all kinds of substrates that are used for electronic materials such as films, clear conductive layers, silicones and glass so that it is efficiently applicable to a wide variety of fields such as solar cells, RFID and PCB.

For better understanding of the present invention, preferred embodiments follow. The following examples are intended to merely illustrate the invention without limiting the scope of the invention.

### Examples

### Examples 1 to 3 and Comparative Examples 1 and 2

The paste compositions were prepared by using the ingredients illustrated in Table 1 below in given amounts and blending them using a 3 roll-mill.

Then, resistivity, viscosity change, resolution, aspect ratio, adhesiveness to substrates and hardness after curing with regard to the paste compositions prepared thereby were measured and shown in Table 1 below.

**Table 1**

| | | | Ex. 1 | Ex. 2 | Ex. 3 | Com. Ex. 1 | Com. Ex. 2 |
|---|---|---|---|---|---|---|---|
| | Conductive Powder | Silver powder | 30 | 70 | 85 | 30 | 85 |
| | Binder 1 | Ethyl cellulose | 10 | 6 | 2 | - | 2 |
| | Binder 2 | Epoxy amine | - | - | - | 10 | 5 |
| | Hardening agent | Amine type | - | - | - | 1 | 0.5 |
| | Monomer | Ethyleneglycoldimethac rylate | 6 | 3 | 4 | - | - |
| Blend (wt.%) | | Trimethylolpropanetriac rylate | 6 | 2 | 1 | - | - |
| | Polymerizat | t-butyl peroxide | 1 | - | - | - | - |
| | ion initiator | t-Butyl peroxyneodecanoate | - | 0.5 | 0.5 | - | - |
| | Organic solvent 1 | Terpineol | 20 | 8 | 3 | 26 | 3 |
| | Organic solvent 2 | Butyl carbitol acetate | 20 | 8 | 3 | 26 | 3 |
| | Plasticizer | Dibutylphthalate | 5 | 1 | - | 5.5 | - |
| | Additive | Foaming agent | 1 | 0.5 | 0.5 | 0.5 | 0.5 |
| | | Dispersing agent | 1 | 1 | 1 | 1 | 1 |
| | Resistivity (*10-6Ωcm) | Curing at 180°C for 30 min | 26.4 | 18.3 | 13.5 | 325 | 114 |
| | | Curing at 200°C for 30 min | 15.7 | 10.2 | 7.18 | 275 | 25.5 |
| Properties | | Curing at 220°C for 30 min | 10.2 | 9.4 | 6.4 | 87.9 | 15.4 |
| | Viscosity change rate (%) | After storage at 25°C for one month | 1.7 | 3.2 | 2.8 | Completely hardened | 32.3 |
| | Resolution (µm) | Line width change rate after printing Within 10% | 50 | 65 | 70 | 90 | 100 |
| | Aspect ratio (%) | Pattern height/pattern line width ratio after curing at 180°C | 16.49 | 22.2 3 | 27.6 6 | 5.13 | 13.1 |
| | Adhesiveness to substrates | Probe-pressed travel mode | 25N | 25N | 25N | 10N | 7N |
| | Hardness after curing | Pencil lead hardness measurement | 4H | 2H | 2H | H | HB |

From Table 1 above, it is shown that the paste compositions of the present invention prepared in Examples 1 to 3 have very excellent electrical resistivity, stability, hardness and adhesiveness to substrates as well as electrode pattern with high resolution and high aspect ratio, in comparison with the paste compositions prepared in Comparative Examples 1 and 2.

The paste composition used for forming an electrode or wiring of the present invention,
1) has excellent printing performance, thereby achieving electrode pattern with high resolution;
2) has superior rheology, thereby achieving a high aspect ratio;
3) has excellent hardness, thereby obtaining excellent electrical resistivity even at low temperatures (400°C or under);
4) has slight viscosity change, thereby being stably stored; and
5) exhibits a high adhesiveness regardless of the texture of substrates (polymers, glass, metals, ceramic and so on), thereby being applicable to a wide variety of fields such as solar cells, RFID and PCB.

## Claims

1. A paste composition used for forming an electrode or wiring, comprising:
a) a conductive powder;
b) a cellulose binder;
c) an acrylate monomer;
d) a radical polymerization initiator; and
e) a solvent.

2. The paste composition used for forming the electrode or wiring as claimed in Claim 1, **characterized in that** it comprises:
a) 30 to 90 % by weight of a conductive powder;
b) 1 to 30 % by weight of a cellulose binder;
c) 1 to 30 % by weight of an acrylate monomer;
d) 0.01 to 10 % by weight of a radical polymerization initiator; and
e) a residual amount of a solvent.

3. The paste composition used for forming the electrode or wiring as claimed in Claim 1, **characterized in that** the conductive powder is Ag powder.

4. The paste composition used for forming the electrode or wiring as claimed in Claim 1, **characterized in that** the conductive powder has an average particle size of 0.05 to 10 µm

5. The paste composition used for forming the electrode or wiring as claimed in Claim 1, **characterized in that** the cellulose binder is selected from the group consisting of methylcellulose, ethylcellulose, propylcellulose, nitrocellulose, acetic acid cellulose, propionic acid cellulose, hydroxyethyl cellulose, hydroxyl propyl cellulose, hydroxyethylhydroxypropyl cellulose and a mixture of two or more kinds thereof.

6. The paste composition used for forming the electrode or wiring as claimed in Claim 1, **characterized in that** the acrylate monomer is one or more kinds selected from the group consisting of trimethylolpropane triacrylate, methacrylic acid, methacrylate, ethylglycidylether methacrylate, propylglycidylether methacrylate, 2 or 4-bromobenzyl methacrylate, hexylmethacrylate, n-octyl methacrylate, isooctyl methacrylate, 2-ethylhexyl methacrylate, isononyl methacrylate, ethylisoamylacrylate, butylglycidylether methacrylate, phenylglycidylether acrylate, tricyclodecyl methacrylate, phenyl methacrylate, benzyl methacrylate, 2 or 4-methoxyphenyl methacrylate, 2 or 4-methoxy benzyl methacrylate, 2 or 4-ethoxyphenyl methacrylate, 2 or 4-ethoxybenzyl methacrylate, 2 or 4-chlorophenyl methacrylate, 2 or 4-chloro benzyl methacrylate, 2 or 4-bromophenyl methacrylate, multi functional monomers such as trimethylolpropane triacrylate, ethyleneglycol dimethacrylate, triethyleneglycol dimethacrylate, 1,3-butanediol dimethacrylate, neopentylglycol dimethacrylate, 1,6-hexanediol dimethacrylate, trimethylol trimethacrylate, trimethylolpropane trimethacrylate, pentaerytritol trimethacrylate, ditrimethylolpropane tetramethacrylate, dipentaerythritol hexylmethacrylate and a mixture thereof.

7. The paste composition used for forming the electrode or wiring as claimed in Claim 1, **characterized in that** the radical polymerization initiator is selected from the group consisting of tert-buylperoxide, tetrabutylperoxide, dilauroyl peroxide, dibenzoyl peroxide, tert-butyl peroxyneodecanoate, tert-amyl peroxypivalate, di(2-ethylhexyl)peroxydicarbonate, di(3-methoxy butyl peroxydicarbonate), 3-hydorxy-1,1-dimethylbutylperoxyneodecanoate, di(3,5,5-trimethylhexanoyl)peroxide, tert-amyl peroxy-2-ethylhexanoate, tert-butyl peroxy-2-ethylhexanoate, tert-butyl-isopropyl monoperoxycarbonate, tert-butylperoxy-2-ethylhexylcarbonate, dibenzoylperoxide, tert-amyl(2-ethylhexyl)monoperoxy carbonate, tert-buylperoxide, tetrabutylperoxide, tert-butylperoxy isopropyl carbonate, tert-butyl peroxy benzoate, 1,1,3,3-tetrametylbutyl peroxyneodecanoate, dicumylperoxide, didecanoyl peroxide and a mixture thereof.

8. The paste composition used for forming the electrode or wiring as claimed in Claim 1, **characterized in that** the composition further comprises a plasticizer, thickening agent, stabilizer, dispersing agent, foaming agent, surfactant and mixture thereof in an amount of 0.01 to 10 % by weight.

9. The paste composition used for forming the electrode or wiring as claimed in Claim 1, **characterized in that** the paste has a viscosity of 1 to 300 Pa.S when measured at a room temperature (25°C).

10. A method of forming an electrode or wiring, comprising coating the paste composition described in any one of Claims 1 to 9 onto a substrate, drying and curing it.

11. The method of forming the electrode or wiring as claimed in Claim 10 **characterized in that** the curing is carried out at a range of 150-400 °C.

12. The method of forming the electrode or wiring as claimed in Claim 10 **characterized in that** the electrode or wiring has a thickness of 3 to 50 µm.

13. The method of forming the electrode or wiring as claimed in Claim 10 **characterized in that** the electrode or wiring is an electrode or wiring for a solar cell, RFID (Radio Frequency Identification) or PCB (Printed Circuit Board).

14. An electrical or optical element **characterized by** comprising the electrode or wiring formed the method of forming the electrode or wiring described in any one of Claims 10 to 13.

15. The electrical or optical element as claimed in Claim 14 **characterized in that** the electrical or optical element is a solar cell, RFID (Radio Frequency Identification) or PCB (Printed Circuit Board).
